# EUROPEAN PATENT SPECIFICATION

(11) **EP 1 660 703 B1**
(45) Date of publication and mention of the grant of the patent: **21.09.2011**
(21) Application number: 04744049.0
(22) Date of filing: 26.07.2004
(51) Int. Cl.: C30B 33/00, C30B 33/06, H01L 21/58

(54) **METHOD OF MANUFACTURING DIAMOND SUBSTRATES**
VERFAHREN ZUR HERSTELLUNG VON DIAMANTSUBSTRATEN
PROCEDE DE FABRICATION DE SUBSTRATS EN DIAMANT

(30) Priority: 30.07.2003 GB 0317854; 06.08.2003 US 492736 P
(43) Date of publication of application: 31.05.2006
(73) Proprietor: Element Six Limited, Isle of Man IM99 6AQ (GB)
(72) Inventor: WORT, Christopher, John, Howard, Wantage, Oxfordshire OX12 7DG (GB); TWITCHEN, Daniel, James, Sunningdale, Berkshire SL5 0BD (GB); SCARSBROOK, Geoffrey Alan, Ascot, Berkshire SL5 9TD (GB)
(74) Representative: Atkinson, Ian Anthony
(86) International application number: PCT/IB2004/002391
(87) International publication number: WO 2005/010245

(56) References cited:
- EP-A- 0 589 464
- WO-A-03/005443
- US-A- 5 198 070
- US-A- 5 420 443
- US-A- 5 672 240
- US-A- 5 907 768
- US-B1- 6 562 127
- PATENT ABSTRACTS OF JAPAN vol. 1996, no. 12, 26 December 1996 (1996-12-26) -& JP 08 208387 A (SUMITOMO ELECTRIC IND LTD), 13 August 1996 (1996-08-13)

## Description

### BACKGROUND OF THE INVENTION

This invention relates to a method of manufacturing single crystal diamond substrates for use in device applications, and to diamond wafers for use in such a method.

Diamond offers a range of unique properties, including optical transmission, thermal conductivity, stiffness, wear resistance and electronic properties. Whilst many of the mechanical properties of diamond can be realised in more than one type of diamond, other properties are very sensitive to the type of diamond used. For example, for the best electronic and other properties, CVD single crystal diamond is important, often outperforming polycrystalline CVD diamond, HPHT diamond and natural diamond.

There are many applications where the workable area or surface of the final diamond product is very small. In such applications it is often difficult to achieve economies of scale or to provide practical methods of processing the single crystal diamond substrates Into the desired devices. Thus, for example, the manufacture of electronic devices on the surfaces of small individual diamond substrates is problematic. Conventional lithographic techniques and existing lithography equipment are not suited to realising some of the complex electronic structures envisaged for such single crystal diamond substrates.

Prior art diamond substrate arrangements are descrided in EP0589464, US5420443, US5907768, US2003/0175531, WO03/005443, US5672240 and US6562127.

### SUMMARY OF THE INVENTION

One aspect of the invention provides a diamond wafer assembly according to claim 1. A second aspect of the invention provides a method according to claim 21.

### DESCRIPTION OF PREFERRED EMBODIMENTS

The invention is directed to providing a tiled array of diamond plates, which is suitable for wafer scale processing, for example, in the manufacture of electronic or other device structures on the diamond plates.

In order to be suitable for wafer scale processing, the diamond plates are preferably single crystal diamond plates. These single crystal diamond plates are preferably either CVD diamond having an accessible upper surface with the lower surface attached to and covered by a support layer. The support layer is polycrystalline CVD diamond and the upper major face may be surrounded by a layer of polycrystalline CVD diamond, whilst the lower major face is brazed to the support layer of polycrystalline CVD diamond.

The accessible surface(s) of each plate, which have been suitably prepared for use in the fabrication of device structures, typically one or both of the major faces, are referred to as the "fabrication surface(s)". These fabrication surfaces are required to fall within a defined tolerance of a single conceptual plane, such that the fabrication surface of each plate within a wafer may be further processed by wafer scale techniques such as those described later. Thus, for instance, where photolithographical techniques are to be applied with a single plane of optical focus, the tolerance of the fabrication surfaces to the conceptual plane should be less than about 100 µm, preferably less than about 25 µm, more preferably less than about 10 µm, even more preferably less than about 5 µm, and most preferably less than about 3 µm. Where mechanical processing techniques are to be applied to the respective fabrication surfaces, for instance, it is preferable that the fabrication surfaces fall within a defined tolerance of a single conceptual plane which is less than about 5 µm, preferably less than about 2 µm, more preferably less than about 1 µm, even more preferably less than about 0.5 µm, and most preferably less than about 0.2 µm. In the case of both the upper and lower surfaces presenting a fabrication surface, each fabrication surface preferably includes the above features.

The single crystal diamond plates or tiles are preferably arranged in an array such that the fabrication surface intended for use on each diamond plate is in an arrangement regular in the sense that it repeats from wafer to wafer, such that jigs for constructing the array and lithography masks or other wafer processing equipment are equally valid for each wafer. A preferred embodiment is where the regularity of the arrangement extends to the arrangement on a single wafer, such that the position of each plate can be described in terms of a regular two dimensional lattice, in a manner akin to atoms in a material lattice. In principle more than one plate can be associated with each lattice point, and each plate associated with a particular lattice point can be of a different geometry, but a preferred embodiment is the case when each single crystal plate is the same shape, and a further preferred embodiment is where there is only one single crystal diamond substrate plate associated with each lattice point.

One embodiment is where the single crystal diamond plates are spaced apart by a small predetermined spacing. The small predetermined spacing is sufficient to avoid contact damage during mounting or thermal cycling, but not so large as to substantially reduce the total packing density on the backing or support layer. This spacing also avoids the problem of dimensional errors in one plate affecting the positioning of those in direct contact with it. Another preferred embodiment is where, in addition, the plates are all rectangular in form. In yet a further embodiment, the single crystal diamond plates are arranged in a well aligned array and significantly spaced apart from one another by a relatively large predetermined spacing.

Those skilled in the art will understand that the existence of small defects in the geometry of individual plates, or in the positioning of individual plates in the array, do not invalidate the general concept of the regular array provided that such defects do not substantially degrade the yield obtainable in the final wafer scale processing.

The array of single crystal diamond plates or tiles is bonded to a backing layer, in particular a polycrystalline CVD diamond layer, which provides matched thermal expansion and good thermal heatsinking during the processing thereof. The bond between the backing layer and the individual tiles is provided by brazing. In order to assist in the function of the diamond wafer, it should exhibit one or more of a high thermal conductivity, stability under high process temperature, for example up to 1100°C, and high mechanical strength to enable wafer scale mechanical processing. Brazing is acceptable for processing temperatures up to about 1100°C, and provides relatively good thermal conductivity and mechanical strength.

The single crystal plates may be bonded to the backing layer in a number of ways. For instance, the single crystal diamond plates can be put into an array, the mounting surface of each single crystal diamond coated with the braze, the backing wafer brought into contact with the single crystal diamond plates (or visa versa), and then the braze activated by heating the assembly. Alternatively, the single crystal diamond plates can be put into an array, the braze positioned suitably on the backing wafer, either as discrete points or a continuous layer, the backing wafer brought into contact with the single crystal diamond plates (or visa versa) and the braze activated by heating the assembly. The excess braze can be removed, for example, by using solvents or an etching process, if this is deemed necessary.

As a further alternative, the backing layer may be prepared and the braze positioned suitably on the backing wafer either as discrete points or a continuous layer. The single crystal diamond plates can then be put individually onto the backing layer, using for example pick and place machinery or other means to position the single crystals according to the desired array, and then the braze activated by heating the assembly. As yet another alternative, the mounting surface of each single crystal diamond can be coated with the braze, and then these assemblies put individually onto the backing layer, using for example pick and place machinery or other means to position the single crystals according to the desired array, and then the braze activated by heating the assembly.

After the single crystal diamond plates have been bonded by brazing onto a backing wafer of polycrystalline CVD diamond or a combination of these, where the backing layer is chosen to be compatible with further diamond growth, a layer of polycrystalline diamond is grown from the front face (which is a fabrication face) of the single crystal diamond array. The growth conditions used can be such as to provide single crystal diamond on the front faces of the single crystal diamond substrates compatible with the application, or the diamond grown in these regions can be subsequently removed, for example by being polished off, or the device faces of the single crystal diamond substrates can be suitably masked to suppress diamond growth in these regions. Once this stage of diamond growth is completed the initial backing layer may be retrained in application or may be removed by etching or other means. In this last case, the final configuration is one where the single crystal diamond plates may be exposed on both surfaces of the supporting polycrystalline diamond surface. This may be beneficial, for example allowing device structures to be completed on both surfaces or the device to be the bulk of the single crystal diamond layer with contacts from both surfaces.

In an alternative not according to the presently claimed invention, a backing layer, preferably a layer of polycrystalline diamond, is grown or otherwise formed onto the back surface of the array of single crystal diamond plates.
a) In the case of a polycrystalline diamond layer, this method forms direct diamond to diamond bonding, or another form of carbon only bonding, the key feature being that the single crystal diamond plates and the polycrystalline diamond are intimately bonded without an interlayer of non-carbon material between them and that the bonding provides a substantial proportion of the beneficial thermal, electrical, mechanical and other properties of a continuous diamond layer. Other benefits in application are that the thermal expansion match of the joint between the array of single-crystals and their supporting layer is perfect, that there are no other materials present that could cause contamination to subsequent processes, and that the dielectric match between the backing or support layer and the array of single crystal diamond plates is the same.
b) Alternatively, the backing layer could be a heat sensitive material, such as a thermoplastic or low melting point metal, a setting material such as a resin, or a deposited material other than CVD diamond, such as produced by solvent deposition or chemical vapour deposition.

A preferred version of the method recited above (not according to the presently claimed invention) is the use of chemical vapour deposition to form a layer of CVD polycrystalline diamond. In this instance the surface on which the array of single crystal plates is placed may act as the hetero-nucleation medium for the polycrystalline diamond, and its exact profile may control the top surface profile of the combined single crystal diamond/polycrystal diamond structure. For example, tungsten or silicon may be used as a flat plate, with the final device face of the single crystal substrates bonded directly to the tungsten by brazing and a conformal coating of polycrystalline diamond grown over the top. Normally growth onto single crystal diamond provides further single crystal growth. However, it may be advantageous to encourage polycrystalline diamond nucleation, which can be achieved in a number of ways. For example, a flash layer of titanium or other metal may be put onto the mounting faces of the single crystal diamond before or after mounting onto the tungsten plate, or the CVD diamond growth may be initiated with a very high methane level to generate multiple nucleation, or the mounting surface of the single crystal diamond can be mechanically roughened by, for example, lapping, or any combination of these and other techniques can be used.

A further arrangement not according to the invention comprises using a temporary carrier for the stage of coating the mounting face of the single crystal diamond with the polycrystalline diamond where that temporary carrier has a profiled face to modify the final composite surface away from flat. For example, an array of pockets separated by ridges would both position the single crystal plates and provide means to control the growth of the polycrystalline diamond so as to provide a non-flat final combination of the single crystal device faces and the upper surface of the polycrystalline diamond layer. Silicon can have a particular advantage in this method of preparation, since micro-machining techniques make built production of the profiled surface a simple bulk operation and chemical etching to remove the silicon is relatively simple.

It is preferred to use a set of single crystal diamond plates that are similar in size and shape to assist in mounting them into an array. However the required tolerances are much less than would be the case for a set of plates intended to butt together in a continuous array that is used for overgrowing a single diamond crystal without discernible boundaries on top. Likewise, aligning a series of non-contacting plates is easier than ensuring precise alignment and uniform regular contact between an array of contacting tiles. Furthermore, in the present invention, an error with one tile position, shape or orientation affects only that tile, and does not affect the other tiles in the diamond wafer.

It is envisaged that the application of the diamond wafer may often benefit from the plates all presenting a physical orientation of minor or major faces within set limits. In order to achieve this, one method is to prepare a single edge and/or a single major face of each of the plates in a manner suitable with the necessary precision, and place this feature in contact with an alignment feature during the process of bonding the plates Into an array, or use it for reference in pick and place methods. In the case of a major face, where only one face is to be processed, this aligned face, which would become the fabrication surface, may be placed against a reference plane during the process of bonding the plates and.any non uniformity in the rear surfaces will be taken up by the bonding process.

Preferably the use of an edge or minor face of the single crystal diamond plates would provide alignment of the minor faces of the plates in the plane parallel to the surface of the backing layer to within a spread (defined as 95% of all plates mounted falling within the range of +/- the spread value about some common direction lying in the plane) of 10°, and more preferably 5°, and most preferably 2°. Preferably the use of major faces of the single crystal diamond plates would provide alignment of fabrication faces of the plates with respect to the plane parallel to the surface of the backing layer to within a spread (defined as 95% of all plates mounted falling within the cone with the given half angle about the normal to the plane of the backing layer) of 5°, and more preferably 2°, and more preferably 1 °, and most preferably 0.5°.

It is also envisaged that the application of the diamond wafer may often benefit from the plates all presenting a similar crystallographic orientation within set limits. In order to achieve this, it is generally only necessary to prepare a single edge and/or a single major face of each of the plates with the necessary precision with respect to the crystal orientation of the plate. In the case of an edge this would be placed in contact with an alignment feature during the process of bonding the plates into an array, or used for reference in pick and place methods, in the case of a major face, where only one face is to be processed, this aligned face, which would become the fabrication surface, may be placed against a reference plane during the process of bonding the plates and any non uniformity in the rear surfaces will be taken up by the bonding process.

Preferably the use of an edge or minor face of the single crystal diamond plates would provide alignment of the crystallographic orientation of the plates in the plane parallel to the surface of the backing layer to within a spread (defined as 95% of all plates mounted falling within the range of +/the spread value about some common direction lying in the plane) of 10°, and more preferably 5°, and most preferably 2°. Preferably the use of major faces of the single crystal diamond plates would provide alignment of the crystallographic orientation of the plates with respect to the plane parallel to the surface of the backing layer to within a spread (defined as 95% of all plates having the same plane normal falling within the cone with the given half angle about the normal to the plane of the backing layer) of 5°, and more preferably 2°, and more preferably 1°, and most preferably 0.5°.

An important application of the diamond wafer assembly of the invention is to provide a means for batch processing of the single crystal diamond plates bonded to it. An important requirement is thus that the layout on the wafer is predetermined, and can be repeated from one wafer to the next, so for example that processing masks or instructions for direct write processes can be set up and used for multiple wafers without modification. In principle this does not require any particular symmetry on an individual wafer, just repeatability from one wafer to the next, but a degree of symmetry or regularity in the packing of an individual wafer generally leads to more efficient packing and ease of use. Furthermore, the diamond wafer assembly is preferably suitable for use in wafer handling equipment, for the automatic processing of the wafers. To assist in this the diamond wafer assembly may have a feature, such as a small flat on one edge, or other aperture, cutout or machine readable marking, to enable automatic determination of its relative orientation in such wafer handling equipment. Such a machine readable feature should provide orientation of the diamond wafer assembly about the axis normal to the wafer which is within a spread (defined as the orientation of 95% of all plates being within +/- the spread value) of 5°, and more preferably 2°, and more preferably 1°, and most preferably 0.5°.

The bonding of the array of single crystal diamond plates together with a polycrystalline diamond layer provides excellent thermal expansion matching between the mounting and the individual plates, ensures maximum thermal conductivity, has a very high temperature stability enabling much higher temperature processes to be used on the plates, and has similar chemical inertness to the single crystal diamond plates so that aggressive chemistries can be used. In addition, following device fabrication onto the surfaces of the individual diamond plates making up the wafer, the device can simply be removed from the wafer by snapping through the polycrystalline diamond layer between the single crystal diamond plates, although laser cutting may be preferred

The combination of single crystal diamond plates bonded to polycrystalline CVD diamond can give unique advantages. This is particularly the case in one further preferred embodiment of the invention, where the single crystal diamond plates are deliberately widely spaced, which then provides each separate single crystal diamond or group of single crystal diamond plates with a substantial attached backing (or in this case surrounding) layer. This provides, for example, a much larger area for thermal heatsinking than merely the footprint of the individual single crystal diamond plates, or enhanced electrical isolation where the device is used in, for example, high voltage or high power electronics. According to the invention as claimed the polycrystalline CVD diamond is bonded to the single crystal diamond by brazing. The bonded polycrystalline backing layer is grown in situ to embed the single crystal diamond plates therein. The backing layer used in this arrangement is polycrystalline CVD diamond.

For the purposes of this specification, the term 'device structures' referring to the structures fabricated onto a surface of the single crystal diamond substrates, refers to any heterogeneous or non-planar structure fabricated into or onto a surface of the single crystal diamond substrate in order to provide or modify the functionality as an electric device, electronic device, optical or mechanical device of which in final application the diamond forms an integral part. By way of non-limiting examples the following may be considered: implanted doping for heater tracks, grooves provided for mechanical or thermal isolation, or for fibre positioning, such as may be used with laser diode arrays, simple or complex electronic devices, from a simple pi junction with contact metallisation, to multi-layer, multi-material, and/or multi-contact devices, optical elements such as micro lenses, micro mirrors for electro-optic or opto-electronic applications, and mechanical constructions such as beams, suspended masses and the like such as may be used in electromechanical devices such as accelerometers, pressure sensors and the like.

The processing steps to produce device structures generally fall into two categories, those which are wafer scale in a simultaneous sense, and those which are wafer scale in a sequential sense.

Examples of wafer scale processes in a simultaneous sense include providing one or more metal layers combined with lithographic techniques and, for example, wet etching or dry plasma etching, to construct electrical contacts to the diamond. Other examples include further diamond coatings, such as doped diamond, to provide contact means or active elements of a device, or uniformly distributed ion implantation processes, and non-diamond coatings such as other semiconductor materials which may provide functional elements in the final devices.

Examples of sequential wafer scale processing include ion implantation using a scanning beam to write device features, where the ion implanter can be pre-programmed to automatically process the entire array of single crystal plates on an individual wafer in a sequential fashion. Similar examples are laser processing, to cut tracks in overlayers or into the diamond itself, and ion beam milling for the fabrication of small detail in devices.

Depending on the relative size of the single crystal diamond substrates and the desired device, there may be one or more devices fabricated into each single crystal diamond substrate. Where more than one device is so formed, one of the wafer scale processes may be the provision of grooves such as those cut by laser into the single crystal substrates to provide means for separation of the devices subsequently, for example by cleavage along said grooves.

A further variant of the invention is where the single crystal plates bonded together by a polycrystalline diamond backing layer or support layer, are used as groups of plates in a further stage of processing or in the final application, still bonded together by said backing layer or support layer. These groups may include any number of the single crystal plates from more than one to the complete assembly of plates formed as the original wafer. In this variant of the invention, the processing of the single crystal plates once in the wafer form is optional, and may include steps such as providing uniform optical polish on one or even both major faces of the plates. In order to retain the strength of the plate assembly and yet enable the rear faces to be polished, the plates may be more widely separated to enable bonding to occur in between the plates rather than across the rear faces, for example so that during the synthesis of the polycrystalline diamond backing layer the wider spaced plates enable growth species to move into the gaps between the plates and form a polycrystalline diamond layer in this location. It may be advantageous to use means such as a backing layer to avoid the growth of the polycrystalline diamond layer onto the rear major face of the plates in this application. Final applications making use of such assemblies of plates include specialist heat sinks, complex sensor and electrical or electro-optic device applications, and multi-window optical applications. The surrounding polycrystalline diamond may then be an integral part of the function of the device assembly, for example providing a larger area for heat sinking, or additional high voltage isolation.

Those skilled in the art will recognize that there are a number of further variations by which the object of this invention can be realized. For example the backing wafer need not be a single layer, but can be a layer of polycrystalline diamond on silicon. In this case the silicon may be removed on final application leaving the single crystal diamond bonded to the polycrystalline diamond layer only.

The invention will now be illustrated by way of the following non-limiting examples:

### Example 1 (Not according to the presently claimed invention)

A set of HPHT single crystal plates were prepared to the following criteria:
a) all the plates were selected from material showing no gross defects or strongly strained regions;
b) all <100> edged plates with no missing corners reducing the <100> edge length by > 15%;
c) all <100> edges between 3.8 and 4.0 mm;
d) all exposed major facets (the fabrication surface) within 2° of the {100};
e) all plates with their opposing major faces parallel to within 3°, and an overall thickness of 0.6 mm +/- 0.02 mm;
f) all plates with one reference edge aligned to the <100> direction to better than 3°; and
g) the fabrication surface finished to an Ra of < 10 nm and prepared in a manner suitable for subsequent electronic use.

The reverse surfaces of the single crystal plates that formed the array were lapped to a surface finish of >200 nm to improve bonding to the subsequent polycrystalline diamond layer.

These single crystal plates were then placed into a prepared alignment mount which caused the individual plates to be closely packed but separated by a small 0.3 mm gap in a well aligned array. The lapped surfaces were placed uppermost. The mount was then placed into a CVD diamond reaction chamber and polycrystalline CVD diamond was formed onto the lapped surface of the array. Although in this example the polycrystalline diamond layer was 350 µm thick, the thickness of the polycrystalline layer can range from 1 or 2 µm through to several mm, if so desired.

Once the array was joined together by the polycrystalline diamond layer it was far more robust and could be handled as a single wafer, no longer requiring the mount to hold the individual crystals together.

The polycrystalline layer can be lapped or polished if required and the array of single crystal surfaces can also be further polished if so required by the subsequent processing steps.

The diamond wafer so produced is suitable for the further processing of the fabrication surfaces to produce single crystal diamond substrates suitable for electronic devices to be applied thereto.

### Example 2 (not according to the present invention)

A set of CVD single crystal plates were prepared using the method revealed in patent application WO 01/96633, and then processed to the criteria marked a) - g) in Example 1. The reverse surfaces and edges of the single crystal plates were lapped to a surface finish of about 1 µm.

These single crystal plates were then placed into a prepared alignment mount fabricated from silicon, which caused the individual plates to be separated by 1.2 cm in a well aligned array using separating ridges 200 µm above the plane on which the crystals were positioned, using a thin layer of thermally conductive paste to temporarily bond and heatsink the plates. The lapped surfaces were placed uppermost. The methods of providing microstructures in silicon wafers are well known to those in the art and provide accurate alignment of the features with the crystal orientation of the wafer.

The mount was then placed into a CVD diamond reaction chamber and polycrystalline CVD diamond was formed onto the lapped surface of the array, using a high methane concentration initially to enhance polycrystalline diamond nucleation on the lapped single crystal surface. The polycrystalline diamond layer was grown to a thickness of 800 µm thickness, then the exposed diamond face planarised by lapping, and a machine readable orientation flat processed by laser machining onto the diamond wafer assembly using the original Si wafer orientation flat as a reference. This enabled the physical orientation of the individual single crystal diamond plates to be set to within 2° spread and, with an orientation spread of <1° for the wafer assembly with respect to the automated wafer handling equipment, within 3° of the orientation of features provided by the automatic wafer handling equipment. Likewise, this procedure enabled the crystallographic orientation of the individual single crystal diamond plates to be set to within a 4° spread and, with an orientation spread of <1° for the wafer assembly with respect to the automated wafer handling equipment, within 5° of the orientation of features provided by the automatic wafer handling equipment.

The device faces of the single crystal plates were then exposed by etching off the silicon. For the purposes of testing, a variety of simple heating element devices were then produced in or on the device surface of the single crystal diamond plates using a combination of implantation, etching by ion beam and by plasma, masking, and further CVD synthesis steps to evaluate bulk processing capabilities and to provide B doped conductive heating tracks and contact pads.

The polycrystalline layer was then divided between the single crystal plates using a laser and the thermal behaviour of the system then tested. The polycrystalline diamond layer being directly bonded to the single crystal layer provided much better and more consistent heat sinking capability than similar structures using an intermediate braze or other form of bonding and would enable higher power devices to run at lower temperatures.

### Example 3 (Not according to the presently claimed invention)

A set of CVD single crystal plates were prepared using the method revealed in patent application WO 01/96633, and then processed to the criteria marked a) - g) in Example 1 with the addition that both major faces were prepared suitable for electronic use. One face of each single crystal plate was then coated with a layer of material to aid recovering that face later. Materials used included silicon and tungsten, and techniques used included evaporation and sputtering, with layers typically 5 - 15 µm thick. The edges of the single crystal plates were then lapped to a surface finish of about 2 µm to assist polycrystalline diamond nucleation.

Each batch treated with a different surface recovery coating was then separately placed into a prepared alignment mount fabricated from silicon, which caused the individual plates to be separated by 1.2 cm in a well aligned array using separating ridges 100 µm above the plane on which the crystals were positioned, using a thin layer of thermally conductive paste to temporarily bond and heatsink the plates, with the coated surfaces exposed. The assembly was then placed into a CVD diamond reaction chamber and a polycrystalline CVD diamond layer was grown between and over the array of crystals, using a high methane concentration initially to enhance polycrystalline diamond nucleation on the lapped single crystal surface. The polycrystalline diamond layer was grown to a thickness of 650 µm. On removal from the reactor the non-planar polycrystalline diamond surface overlaying the surface recovery coating was then planarised by lapping, and then further thinned to expose the surface recovery coating. This final thinning was in some instances by lapping and in some instances using hot metal thinning, which used the surface recovery coating as a natural etch stop. Finally, the surface recovery coating was removed from the single crystal plates by chemical etching. This provided a polycrystalline diamond layer about 480 µm thick with embedded single crystal diamond plates exposed on both surfaces, with both surfaces of the single crystal already suitably prepared for electronic applications. The method provided the physical orientation of the major faces of the plates within a spread of 2° of the plane defined by the backing layer, and likewise because of the initial preparation of the substrates, provided the crystallographic orientation of the major faces of the plates within a spread of 4° of the plane defined by the backing layer (i.e. the {100} of at least 95% of the plates was within 4° of the plane of the backing layer and the diamond wafer assembly of which it formed a part).

Three types of device were then fabricated from these structures. The first was optical windows with anti-reflection coatings, where the AR coating could be fabricated across the entire array as one batch. The second was detector devices where the charge pickup and contact pads could be fabricated on both sides of the single crystal plates using wafer scale technology. The third device type was an optically or electron beam activated high voltage switch, again processed using wafer scale processes.

The polycrystalline diamond layer was separated by laser to provide individual and small groups of single crystal plates surrounded by a polycrystalline diamond frame for final device testing.

The additional polycrystalline frame provided a) a means of mounting and cooling the single crystal diamond window, b) a means of mounting and improving handling of the detector, and of providing detector arrays, and c) a means of providing useful electrical isolation against the risk of flashover for the high voltage switch.

### Example 4

A set of CVD single crystal plates were prepared using the method revealed in patent application WO 01/96633, and then processed to the criteria marked a) - g) in Example 1.

The sides and reverse surfaces of the single crystal plates were lapped to a surface finish of > 500 nm to improve bonding to the subsequent polycrystalline diamond layer and the plated device placed face down in an array onto a sticky or tactile surface to retain their positioning. Braze paste was placed onto each of the plates, and then the lapped surface of a polycrystalline diamond wafer brought into contact and the whole assembly heated to the melting point of the braze paste (about 800°C) to form a single wafer array of single crystal diamond plates suitable for further batch processing.

### Example 5

A set of HPHT single crystal plates were prepared with thin (20 µm) thick device quality CVD diamond grown onto one surface using the method revealed in patent application WO 01/96633, and then the plates processed to the criteria marked a) - g) in Example 1. The back face of each plate was lapped to >500 nm.

A polycrystalline CVD diamond disc was produced 100 mm in diameter and 300 µm thick on top of a silicon wafer, and then the surface lapped flat to a 5 µm Ra. A second silicon wafer was prepared without the polycrystalline diamond coating.

Each wafer was then processed as follows:

A braze paste was applied to the lapped face of each of the single crystal diamond plates and then using pick and place technology each was positioned onto the wafer. When the wafer was fully populated with the array of single crystal diamond plates a compressor plate was brought in contact with the upper surface of the single crystal diamond plates to ensure correct height/flatness and then the assembly was heated sufficient to melt the braze and affix the single crystal diamond plates to the wafer to form a single wafer array of single crystal diamond plates suitable for further batch processing.

## Claims

1. A diamond wafer assembly for use in a method of processing single crystal diamond substrates, comprising a plurality of single crystal diamond plates fixed to a polycrystalline CVD diamond support layer in a substantially planar arrangement such that at least one of the major surfaces of the respective fixed single crystal diamond plates defines a fabrication surface that is exposed for further processing, wherein the single crystal diamond plates are bonded to the polycrystalline CVD diamond support layer by a metal braze, wherein a polycrystalline CVD diamond layer extends between the respective single crystal diamond plates so as to embed at least a portion of the single crystal diamond plates therein, and the polycrystalline CVD diamond support layer forms a bracking layer for the single crystal diamond plates.

2. A diamond wafer assembly according to any one of the preceding claims, wherein the single crystal diamond plates are CVD diamond plates.

3. A diamond wafer assembly according to any one of the preceding claims, wherein the single crystal diamond plates are arranged in a predetermined array.

4. A diamond wafer assembly according to claim 1, wherein the predetermined array is regular and based on a two dimensional array of lattice points with one or more plates associated with each lattice point.

5. A diamond wafer assembly according to any one of the preceding claims, wherein the diamond wafer assembly Is suitable for automatic wafer handling equipment and provides an orientation feature which is machine readable and provides orientation of the diamond wafer assembly about its normal axis within certain limits.

6. A diamond wafer assembly according claim 5, wherein the machine readable orientation feature enables orientation to be achieved within a spread of 5°.

7. A diamond wafer assembly according to any preceding claim, wherein the tolerance of the respective fabrication surfaces to a single conceptual plane is less than about 100 µm.

8. A diamond wafer assembly according to claim 7, wherein the tolerance of the respective fabrication surfaces to the conceptual plane is less than about 10 µm.

9. A diamond wafer assembly according to claim 8, wherein the tolerance of the respective fabrication surfaces to the conceptual plane is less than about 5 µm.

10. A diamond wafer assembly according to claim 9, wherein the tolerance of the respective fabrication surfaces to the conceptual plane is less than about 3 µm.

11. A diamond wafer assembly according to claim 10, wherein the tolerance of the respective fabrication surfaces to the conceptual plane is less than about 1 µm.

12. A diamond wafer assembly according to claim 11, wherein the tolerance of the respective fabrication surfaces to the conceptual plane is less than about 0.2 µm.

13. A diamond wafer assembly according to any preceding claim, wherein the single crystal diamond plates are arranged in a well-aligned array and spaced from one another by a predetermined spacing.

14. A diamond wafer assembly according to any one of the preceding claims, wherein the support layer further comprises a tungsten backing wafer.

15. A diamond wafer assembly according to any one of the preceding claims, wherein the single crystal diamond plates are arranged in an array, wherein the physical orientation of the single crystal diamond plates parallel to the plane of the support layer lies within a spread of 10°.

16. A diamond wafer assembly according to claim 15, wherein the physical orientation of the single crystal diamond plates parallel to the plane of the support layer lies within a spread of 5°.

17. A diamond wafer assembly according to any one of the preceding claims, wherein the single crystal diamond plates are arranged in a array, wherein the crystallographic orientation of the single crystal diamond plates parallel to the plane of the support layer lies within a spread of 10°.

18. A diamond wafer assembly according to claim 17, wherein the crystallographic orientation of the single crystal diamond plates parallel to the plane of the support layer lies within a spread of 5°.

19. A diamond wafer assembly according to any preceding claim, wherein the assembly can be separated into one or more single crystal diamond substrates in which the support layer has a greater area than the single crystal diamond substrate(s).

20. A diamond wafer assembly according to claim 19, wherein the single crystal diamond substrates attached to the support layer can be used in optical, thermal, mechanical or electronic applications, or combinations thereof.

21. A method of producing single crystal diamond substrates, the method including the steps of providing a plurality of single crystal diamond plates, each diamond plate having a pair of opposite major surfaces, one or both of the major surfaces defining a fabrication surface; brazing the diamond plates in a substantially planar array to a polycrystalline CVD diamond support layer to form a diamond wafer assembly; processing as required the fabrication surfaces to produce respective single crystal diamond substrates; and growing a layer of polycrystalline CVD diamond between the respective single crystal diamond plates such that the polycrystalline CVD diamond extends between the respective single crystal diamond plates and embeds at least a portion of the single crystal diamond plates therein.

22. A method according to claim 21, wherein the support layer is bonded to the single crystal diamond plates, collectively or individually.

23. A method according to claims 21 to 22, wherein the fabrication surfaces are processed to provide electronic or other device features on the single crystal diamond substrates.

24. A method according to claim 23, wherein the electronic or other device features are formed by lithographic techniques.

25. A method according to claim 23, wherein the electronic or other device features are formed by mechanical processing techniques.

26. A method according to any preceding claim, wherein the support layer is further processed so as to expose both major surfaces, of the single crystal diamond plates for further processing.

27. A method according to any one of claims 21 to 26, wherein the support layer further comprises a tungsten backing wafer.

28. A method according to any one of claims 21 to 27, wherein the diamond wafer assembly is cleaved so as to produce individual single crystal diamond substrates or groups thereof.

29. A method according to claim 28. wherein the diamond wafer assembly is cleaved in such a manner that the support layer remaining on individual substrates or groups thereof is complimentary in area to the individual substrate or groups thereof, respectively.

30. A method according to claim 28, wherein the diamond wafer assembly is cleaved In such a manner that the support layer remaining on individual substrates or groups thereof is larger in area than the individual substrate or groups thereof, respectively.

31. A method according to any one of claims 21 to 30, wherein each of the single crystal diamond plates has one or more minor surfaces that are prepared to provide crystallographic alignment of the plate with the support layer.

32. A method according to claim 31, wherein the one or more minor surfaces are brought into contact with detail on the support layer, or a temporary substrate used in the method, to provide crystallographic alignment of the plate with the support layer.

## Patentansprüche

1. Diamant-Wafer-Verbund zur Verwendung in einem Verfahren zur Verarbeitung von Einkristall-Diamantsubstraten, welcher eine Mehrzahl von Diamantplatten umfasst, die an einer polykristallinen CVD-Diamant-Trägerschicht (CVD:
chemische Gasabscheidung, chemical vapor deposition) in einer im Wesentlichen planaren Ausrichtung fixiert sind,
so dass mindestens eine der Hauptoberflächen der jeweiligen fixierten Einkristall-Diamantplatte eine Fertigungsoberfläche definiert, die weiterer Verarbeitung ausgesetzt wird, wobei die Einkristall-Diamantplatten an die polykristalline CVD-Diamant-Trägerschicht durch eine Metall-Hartlötstelle gebunden sind, wobei sich eine polykristalline CVD-Diamantschicht zwischen den jeweiligen Einkristall-Diamantplatten erstreckt, so dass zumindest ein Teil der Einkristall-Diamantplatten darin eingebettet ist, und die polykristalline CVD-Diamant-Trägerschicht eine Stützschicht für die Einkristall-Diamantplatten bildet.

2. Diamant-Wafer-Verbund nach einem der vorhergehenden Ansprüche, bei dem die Einkristall-Diamantplatten CVD-Diamantplatten sind.

3. Diamant-Wafer-Verbund nach einem der vorhergehenden Ansprüche, bei dem die Einkristall-Diamantplatten in einer vorherbestimmten Anordnung angeordnet sind.

4. Diamant-Wafer-Verbund nach Anspruch 1, bei dem die vorherbestimmte Anordnung regelmäßig ist und auf einer zweidimensionalen Anordnung von Gitterpunkten basiert, wobei eine oder mehrere Platten zu jedem Gitterpunkt zugehörig sind.

5. Diamant-Wafer-Verbund nach einem der vorhergehenden Ansprüche, wobei der Diamant-Wafer-Verbund für automatisches Wafer-Handhabungs-Arbeitsgerät geeignet ist und ein Orientierungsmerkmal bereitstellt, welches maschinenlesbar ist und Orientierung des Diamant-Wafer-Verbunds um seine Normalachse innerhalb bestimmter Grenzen ermöglicht.

6. Diamant-Wafer-Verbund nach Anspruch 5, wobei das maschinenlesbare Orientierungsmerkmal ermöglicht, dass eine Orientierung innerhalb einer Spanne von 5° erzielt wird.

7. Diamant-Wafer-Verbund nach einem vorhergehenden Anspruch, bei dem die Abweichung der jeweiligen Fertigungsoberflächen von einer einzigen konzeptionellen Fläche weniger als etwa 100 µm beträgt.

8. Diamant-Wafer-Verbund nach Anspruch 7, bei dem die Abweichung der jeweiligen Fertigungsoberflächen von der konzeptionellen Fläche weniger als etwa 10 µm beträgt.

9. Diamant-Wafer-Verbund nach Anspruch 8, bei dem die Abweichung der jeweiligen Fertigungsoberflächen von der konzeptionellen Fläche weniger als etwa 5 µm beträgt.

10. Diamant-Wafer-Verbund nach Anspruch 9, bei dem die Abweichung der jeweiligen Fertigungsoberflächen von der konzeptionellen Fläche weniger als etwa 3 µm beträgt.

11. Diamant-Wafer-Verbund nach Anspruch 10, bei dem die Abweichung der jeweiligen Fertigungsoberflächen von der konzeptionellen Fläche weniger als etwa 1 µm beträgt.

12. Diamant-Wafer-Verbund nach Anspruch 11, bei dem die Abweichung der jeweiligen Fertigungsoberflächen von der konzeptionellen Fläche weniger als etwa 0,2 µm beträgt.

13. Diamant-Wafer-Verbund nach einem vorhergehenden Anspruch, bei dem die Einkristall-Diamantplatten in einer gut ausgerichteten Anordnung angeordnet und voneinander mit einem vorherbestimmten Abstand beabstandet sind.

14. Diamant-Wafer-Verbund nach einem der vorhergehenden Ansprüche, bei dem die Trägerschicht des weiteren einen Wolfram-Stütz-Wafer umfasst.

15. Diamant-Wafer-Verbund nach einem der vorhergehenden Ansprüche, bei dem die Einkristall-Diamantplatten in einer Anordnung angeordnet sind, bei der die physische Orientierung der Einkristall-Diamantplatten innerhalb einer Spanne von 10° parallel zur Ebene der Trägerschicht liegt.

16. Diamant-Wafer-Verbund nach Anspruch 15, bei dem die physische Orientierung der Einkristall-Diamantplatten innerhalb einer Spanne von 5° parallel zur Ebene der Trägerschicht liegt.

17. Diamant-Wafer-Verbund nach einem der vorhergehenden Ansprüche, bei dem die Einkristall-Diamantplatten in einer Anordnung angeordnet sind, bei der die kristallographische Orientierung der Einkristall-Diamantplatten innerhalb einer Spanne von 10° parallel zur Ebene der Trägerschicht liegt.

18. Diamant-Wafer-Verbund nach Anspruch 17, bei dem die kristallographische Orientierung der Einkristall-Diamantplatten innerhalb einer Spanne von 5° parallel zur Ebene der Trägerschicht liegt.

19. Diamant-Wafer-Verbund nach einem der vorhergehenden Ansprüche, wobei der Verbund in ein oder mehrere Einkristall-Diamantsubstrate getrennt werden kann, bei denen die Trägerschicht eine größere Fläche als das Einkristall-Diamantsubstrat oder die Einkristall-Diamantsubstrate hat.

20. Diamant-Wafer-Verbund nach Anspruch 19, wobei das an die Trägerschicht angefügte Einkristall-Diamantsubstrat in optischen, thermischen, mechanischen oder elektronischen Anwendungen oder Kombinationen derselben verwendet werden kann.

21. Verfahren zur Erstellung von Einkristall-Diamantsubstraten, wobei das Verfahren folgende Stufen umfasst:
Bereitstellen einer Mehrzahl von Einkristall-Diamantplatten, wobei jede Diamantplatte ein Paar gegenüberliegender Hauptoberflächen hat, wobei eine oder beide der Hauptoberflächen eine Fertigungsoberfläche definieren;
Löten der Diamantplatten in einer im Wesentlichen planaren Anordnung auf eine polykristalline CVD-Diamant-Trägerschicht, um einen Diamant-Wafer-Verbund zu erzeugen; Verarbeiten der Fertigungsoberflächen je nach Bedarf, um jeweils Einkristall-Diamantsubstrate herzustellen; und
Wachsenlassen einer Schicht von polykristallinen CVD-Diamanten zwischen den jeweiligen Einkristall-Diamantplatten, so dass sich der polykristalline CVD-diamant zwischen den jeweiligen Einkristall-Diamantplatten erstreckt und mindestens ein Teil der Einkristall-Diamantplatten darin eingebettet ist.

22. Verfahren nach Anspruch 21, bei dem die Trägerschicht kollektiv oder individuell an die Einkristall-Diamantplatten gebunden ist.

23. Verfahren nach Anspruch 21 oder 22, bei dem die Fertigungsoberflächen verarbeitet werden, um elektronische oder andere Baustein-Merkmale auf den Einkristall-Diamantsubstraten bereitzustellen.

24. Verfahren nach Anspruch 23, bei dem die elektronischen oder anderen Baustein-Merkmale durch lithografische Techniken gebildet werden.

25. Verfahren nach Anspruch 23, bei dem die elektronischen oder anderen Baustein-Merkmale durch mechanische Verarbeitungstechniken gebildet werden.

26. Verfahren nach einem vorhergehenden Anspruch, bei dem die Trägerschicht weiter verarbeitet wird, um beide Hauptoberflächen der Einkristall-Diamantplatten für die Weiterverarbeitung freizulegen.

27. Verfahren nach einem der Ansprüche 21 bis 26, bei dem die Trägerschicht des weiteren einen Wolfram-Stütz-Wafer umfasst.

28. Verfahren nach einem der Ansprüche 21 bis 27, bei dem der Diamant-Wafer-Verbund zerteilt wird, um einzelne Einkristall-Diamantsubstrate oder Gruppen derselben herzustellen.

29. Verfahren nach Anspruch 28, bei dem der Diamant-Wafer-Verbund auf solche Weise zerteilt wird, dass die auf einzelnen Substraten oder Gruppen derselben verbleibende Trägerschicht komplementär in der Fläche zu den einzelnen Substraten beziehungsweise Gruppen derselben ist.

30. Verfahren nach Anspruch 28, bei dem der Diamant-Wafer-Verbund auf solche Weise zerteilt wird, dass die auf einzelnen Substraten oder Gruppen derselben verbleibende Trägerschicht größer an Fläche als die einzelnen Substrate beziehungsweise Gruppen derselben ist.

31. Verfahren nach einem der Ansprüche 21 bis 30, bei dem jede der Einkristall-Diamantplatten eine oder mehrere kleinere Oberflächen hat, die vorbereitet werden, damit sie kristallographische Abgleichung der Platte mit der Trägerschicht erbringen.

32. Verfahren nach Anspruch 31, bei dem eine oder mehrere kleinere Oberflächen mit Detail auf der Trägerschicht oder einem in dem Verfahren verwendeten temporären Substrat in Kontakt gebracht werden, um kristallographische Angleichung der Platte mit der Trägerschicht zu verbringen.

## Revendications

1. Ensemble de plaquette en diamant à utiliser dans un procédé de traitement de substrats en diamant monocristallin, comprenant une pluralité de plaques en diamant monocristallin fixées à une couche support en diamant CVD polycristallin selon un agencement sensiblement planaire de sorte qu'au moins l'une des surfaces principales des plaques en diamant monocristallin fixées respectives définit une surface de fabrication qui est exposée pour un traitement additionnel, dans lequel les plaques en diamant monocristallin sont liées à la couche support en diamant CVD polycristallin par brasage métallique, dans lequel une couche support en diamant CVD polycristallin s'étend entre les plaques en diamant monocristallin respectives de manière à y incorporer au moins une partie des plaques en diamant monocristallin, et la couche support en diamant CVD polycristallin forme une couche de support pour les plaques en diamant monocristallin.

2. Ensemble de plaquette en diamant selon l'une quelconque des revendications précédentes, dans lequel les plaques en diamant monocristallin sont des plaques en diamant CVD.

3. Ensemble de plaquette en diamant selon l'une quelconque des revendications précédentes, dans lequel les plaques en diamant monocristallin sont agencées selon une disposition prédéterminée.

4. Ensemble de plaquette en diamant selon la revendication 1, dans lequel la disposition prédéterminée est régulière et se base sur une disposition à deux dimensions de points de treillis, une ou plusieurs plaques étant associées à chaque point de treillis.

5. Ensemble de plaquette en diamant selon l'une quelconque des revendications précédentes, dans lequel l'ensemble de plaquette en diamant est approprié pour un équipement de manipulation automatique de plaquettes et procure une propriété d'orientation qui est lisible par machine et procure une orientation de l'ensemble de plaquette en diamant autour de son axe normal dans certaines limites.

6. Ensemble de plaquette en diamant selon la revendication 5, dans lequel la propriété d'orientation lisible par machine permet d'atteindre une orientation dans une plage de 5°.

7. Ensemble de plaquette en diamant selon l'une quelconque des revendications précédentes, dans lequel la tolérance des surfaces de fabrication respectives à un plan conceptuel unique est inférieure à environ 100 µm.

8. Ensemble de plaquette en diamant selon la revendication 7, dans lequel la tolérance des surfaces de fabrication respectives au plan conceptuel est inférieure à environ 10 µm.

9. Ensemble de plaquette en diamant selon la revendication 8, dans lequel la tolérance des surfaces de fabrication respectives au plan conceptuel est inférieure à environ 5 µm.

10. Ensemble de plaquette en diamant selon la revendication 9, dans lequel la tolérance des surfaces de fabrication respectives au plan conceptuel est inférieure à environ 3 µm.

11. Ensemble de plaquette en diamant selon la revendication 10, dans lequel la tolérance des surfaces de fabrication respectives au plan conceptuel est inférieure à environ 1 µm.

12. Ensemble de plaquette en diamant selon la revendication 11, dans lequel la tolérance des surfaces de fabrication respectives au plan conceptuel est inférieure à environ 0,2 µm.

13. Ensemble de plaquette en diamant selon l'une quelconque des revendications précédentes, dans lequel les plaques en diamant monocristallin sont agencées selon une disposition bien alignée et espacées entre elles par un espacement prédéterminé.

14. Ensemble de plaquette en diamant selon l'une quelconque des revendications précédentes, dans lequel la couche support comprend en outre une plaquette de support au tungstène.

15. Ensemble de plaquette en diamant selon l'une quelconque des revendications précédentes, dans lequel les plaques en diamant monocristallin sont agencées selon une disposition, dans lequel l'orientation physique des plaques en diamant monocristallin parallèles au plan de la couche support se trouve dans une plage de 10°.

16. Ensemble de plaquette en diamant selon la revendication 15, dans lequel l'orientation physique des plaques en diamant monocristallin parallèles au plan de la couche support se trouve dabs une plage de 5°.

17. Ensemble de plaquette en diamant selon l'une quelconque des revendications précédentes, dans lequel les plaques en diamant monocristallin sont agencées selon une disposition, dans lequel l'orientation cristallographique des plaques en diamant monocristallin parallèles au plan de la couche support se trouve dans une plage de 10°.

18. Ensemble de plaquette en diamant selon la revendication 17, dans lequel l'orientation cristallographique des plaques en diamant monocristallin parallèles au plan de la couche support se trouve dans une plage de 5°.

19. Ensemble de plaquette en diamant selon l'une quelconque des revendications précédentes, dans lequel l'ensemble peut être séparé en un ou plusieurs substrats en diamant monocristallin dans lesquels la couche support a une plus grande superficie que le ou les substrats en diamant monocristallin.

20. Ensemble de plaquette en diamant selon la revendication 19, dans lequel les substrats en diamant monocristallin attachés à la couche support peuvent être utilisés dans des applications optiques, thermiques, mécaniques ou électroniques ou dans des combinaisons celles-ci.

21. Procédé de fabrication de substrats en diamant monocristallin, le procédé comprenant les étapes consistant à : prévoir une pluralité de plaques en diamant monocristallin, chaque plaque en diamant comprenant une paire de surfaces principales opposées, l'une ou les deux surfaces principales définissant une surface de fabrication ; lier par brasage les plaques en diamant, selon une disposition sensiblement planaire, à une couche support en diamant CVD polycristallin afin de former un ensemble de plaquette en diamant ; traiter selon le besoin les surfaces de fabrication afin de produire des substrats en diamant monocristallin respectifs ; et faire croître une couche de diamant CVD polycristallin entre les plaques en diamant monocristallin respectives de sorte que le diamant CVD polycristallin s'étend entre les plaques en diamant monocristallin respectives et y incorpore au moins une partie des plaques en diamant monocristallin.

22. Procédé selon la revendication 21, dans lequel la couche support est liée aux plaques en diamant monocristallin, collectivement ou individuellement.

23. Procédé selon les revendications 21 à 22, dans lequel les surfaces de fabrication sont traitées pour fournir des propriétés électroniques ou d'autres propriétés de dispositif sur les substrats en diamant monocristallin.

24. Procédé selon la revendication 23, dans lequel les propriétés électroniques ou autres propriétés de dispositif sont formées par des techniques lithographiques.

25. Procédé selon la revendication 23, dans lequel les propriétés électroniques ou autres propriétés de dispositif sont formées par des techniques de traitement mécanique.

26. Procédé selon l'une quelconque des revendications précédentes, dans lequel la couche support est traitée plus en avant de manière à exposer les deux surfaces principales des plaques en diamant monocristallin pour un traitement additionnel.

27. Procédé selon l'une quelconque des revendications 21 à 26, dans lequel la couche support comprend en outre une plaquette de support au tungstène.

28. Procédé selon l'une quelconque des revendications 21 à 27, dans lequel l'ensemble de plaquette en diamant est séparé afin de produire des substrats en diamant monocristallin individuels ou des groupes de ces derniers.

29. Procédé selon la revendication 28, dans lequel l'ensemble de plaquette en diamant est séparé de sorte que la couche support restant sur des substrats individuels ou des groupes de ces derniers soit complémentaire en termes de superficie à un substrat individuel ou des groupes de ce dernier, respectivement.

30. Procédé selon la revendication 28, dans lequel l'ensemble de plaquette en diamant est séparé de sorte que la couche support restant sur des substrats individuels ou des groupes de ces derniers présente une plus grande superficie que le substrat individuel ou les groupes de ce dernier, respectivement.

31. Procédé selon l'une quelconque des revendications 21 à 30, dans lequel chacune des plaques en diamant monocristallin comprend une ou plusieurs surfaces mineures qui sont préparées pour conférer un alignement cristallographique de la plaque avec la couche support.

32. Procédé selon la revendication 31, dans lequel la ou les plusieurs surfaces mineures sont mises en contact de façon minutieuse sur la couche support, ou sur un substrat temporaire utilisé dans le procédé, pour conférer un alignement cristallographique de la plaque avec la couche support.
